(19) Europäisches Patentamt / European Patent Office / Office européen des brevets

(11) **EP 4 401 038 A1**

(12) **EUROPEAN PATENT APPLICATION**
published in accordance with Art. 153(4) EPC

(43) Date of publication:
**17.07.2024 Bulletin 2024/29**

(21) Application number: **22883854.6**

(22) Date of filing: **12.10.2022**

(51) International Patent Classification (IPC):
**G06T 11/00** *(2006.01)*      **G06T 3/40** *(2024.01)*
**G06N 3/08** *(2023.01)*

(52) Cooperative Patent Classification (CPC):
**G06N 3/08; G06T 3/40; G06T 11/00**

(86) International application number:
**PCT/KR2022/015357**

(87) International publication number:
**WO 2023/068631 (27.04.2023 Gazette 2023/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:  **18.10.2021   KR 20210138141**
**02.12.2021   KR 20210170519**

(71) Applicant: **Lightvision Inc.**
**Seoul 04793 (KR)**

(72) Inventors:
• **JEONG, Jin Ha**
**Yongin-si, Gyeonggi-do 16960 (KR)**
• **RA, Moon Soo**
**Bucheon-si, Gyeonggi-do 14539 (KR)**
• **LEE, Hea Yun**
**Suwon-si, Gyeonggi-do 16517 (KR)**
• **LEE, Hyun Ji**
**Seoul 06074 (KR)**

(74) Representative: **BCKIP Part mbB**
**Siegfriedstraße 8**
**80803 München (DE)**

(54) **SYSTEM AND METHOD FOR GENERATING TEM SADP IMAGE WITH HIGH DISTINGUISHABILITY**

(57)      A system and a method of generating adaptively a TEM SADP image with high discernment according to inputted parameters are disclosed. The system for generating a diffraction pattern image includes a sample generating unit configured to generate a sample by using at least one of a parameter about a lattice constant, a parameter about relative location of atom in unit lattice and a parameter about a zone axis, a vector generating unit configured to generate a reciprocal lattice vector corresponding to the unit lattice, a light source generating unit configured to calculate brightness of an electron beam reached to atom in the generated sample and a diffraction pattern generating unit configured to generate synthetic diffraction pattern image by using the generated reciprocal lattice vector, the relative location of atom in the sample and the calculated brightness of the electron beam.

**FIG. 6**

**Description**

TECHNICAL FIELD

The present disclosure relates to a system and a method of generating adaptively a TEM SADP image with high discernment according to inputted parameters.

BACKGROUND ART

Conventional technique generates a TEM (Transmission Electron Microscope) SADP (Selected Area Diffraction Pattern) image not similar to real SADP image photographed by a TEM device and much time is required for generating the TEM SADP image.

Additionally, a ringing effect due to a discontinuity point of a light source occurs in a process of generating the SADP image, HOLZ (High Order Laue Zone) is included in a diffraction pattern, or the diffraction pattern of which a diffraction point is blurred is generated.

For example, the generated SADP image should be similar to real TEM SADP image shown in FIG. 1, but the SADP image generated by conventional technique, e.g., synthetic SADP image generated by using a JEMS program or a Condor program includes the HOLZ pattern shown in FIG. 3 or blurred diffraction point shown in FIG. 4. Furthermore, the ringing effect occurs to the generated SADP image as shown in FIG. 5.

SUMMARY

The present disclosure is to provide a system and a method of generating adaptively a TEM SADP image with high discernment according to inputted parameters.

Additionally, the present disclosure is to provide a system and a method of generating synthetic diffraction pattern image which is usable for a TEM.

Furthermore, the present disclosure is to provide a technique for preventing a ringing effect or a phenomenon that HOLZ or blurred diffraction point is included in the diffraction pattern image.

Moreover, the present disclosure is to provide a technique for generating a diffraction pattern image by interpreting mathematically parameters inputted by a user.

In addition, the present disclosure is to provide a computing device with rapid processing speed using a parallel processing of a CPU or a GPGPU.

Furthermore, the present disclosure is to provide a technique using an image processing technique such as gamma correction.

Moreover, the present disclosure is to provide a technique using the SADP image generated adaptively depending on inputted parameters.

Additionally, the disclosure is to provide a technique for preventing a phenomenon that material is broken down because an electron beam is emitted to the material too many times.

A system for generating a diffraction pattern image according to an embodiment of the present disclosure includes a sample generating unit configured to generate a sample by using at least one of a parameter about a lattice constant, a parameter about relative location of atom in unit lattice and a parameter about a zone axis; a vector generating unit configured to generate a reciprocal lattice vector corresponding to the unit lattice; a light source generating unit configured to calculate brightness of an electron beam reached to atom in the generated sample; and a diffraction pattern generating unit configured to generate synthetic diffraction pattern image by using the generated reciprocal lattice vector, the relative location of atom in the sample and the calculated brightness of the electron beam.

A system for generating a diffraction pattern image according to another embodiment of the present disclosure includes a sample generating unit configured to generate a slab-type sample by using parameters inputted by a user; and a diffraction pattern generating unit configured to generate the diffraction pattern image by using parameters obtained by analyzing the generated sample. Here, the sample generating unit determines adaptively the number of layers of a slab according to a parameter about a lattice constant and a parameter about a zone axis of the inputted parameters.

A system for generating a diffraction pattern image according to still another embodiment of the present disclosure includes a sample generating unit configured to generate a slab-type sample by using parameters inputted by a user; a light source generating unit configured to calculate brightness of an electron beam reached to atom in the sample by using inputted shape and intensity of a light source; and a diffraction pattern generating unit configured to generate synthetic diffraction pattern image by using location of atom in the sample and the calculated brightness of the electron beam. Here, the shape and the intensity of the light source is adaptively changed depending on inputted size of a slab or inputted size of the diffraction pattern image, to prevent a ringing effect of a diffraction pattern occurred from a discontinuity point of the light source.

A recording medium readable by a computer recording a program code according to an embodiment of the present disclosure, wherein the program code is used for performing a method comprising: generating a sample by using at least one of a parameter about a lattice constant, a parameter about relative location of atom in unit lattice and a parameter about a zone axis; generating a reciprocal lattice vector meeting with Eward sphere corresponding to the unit lattice; calculating brightness of an electron beam reached to atom in the sample by using inputted shape and intensity of a light source; and generating synthetic diffraction pattern image by using the generated reciprocal lattice vector, the relative location of atom in the sample and the calculated brightness of the electron beam. Here, the diffraction pattern image is a TEM SADP image.

A system and a method of generating a TEM SADP image according to an embodiment of the present disclosure may prevent a phenomenon that HOLZ or blurred diffraction point is included in a diffraction pattern and a ringing effect of the diffraction pattern occurred due to a discontinuity point of a light source according to inputted parameters.

BRIEF DESCRIPTION OF DRAWINGS

Example embodiments of the present disclosure will become more apparent by describing in detail example embodiments of the present disclosure with reference to the accompanying drawings, in which:

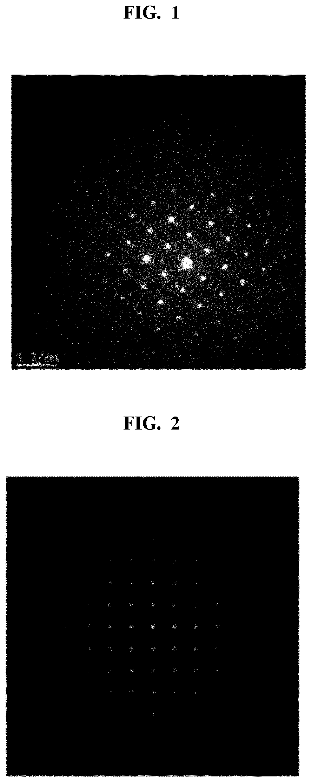

FIG. 1 is a view illustrating an example of real TEM SADP image;
FIG. 2 is a view illustrating synthetic SADP image generated through a JEMS program;

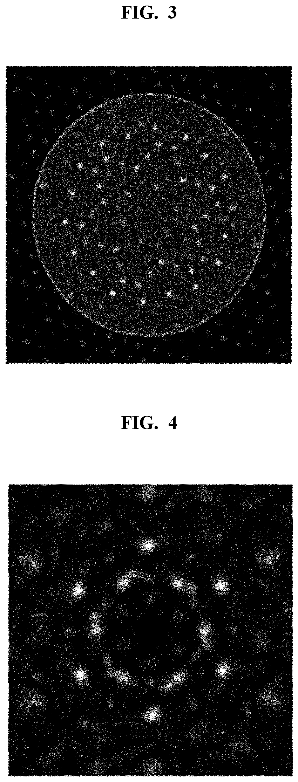

FIG. 3 is a view illustrating an SADP image where HOLZ pattern is included;
FIG. 4 is a view illustrating an SADP image where blurred diffraction point is included;

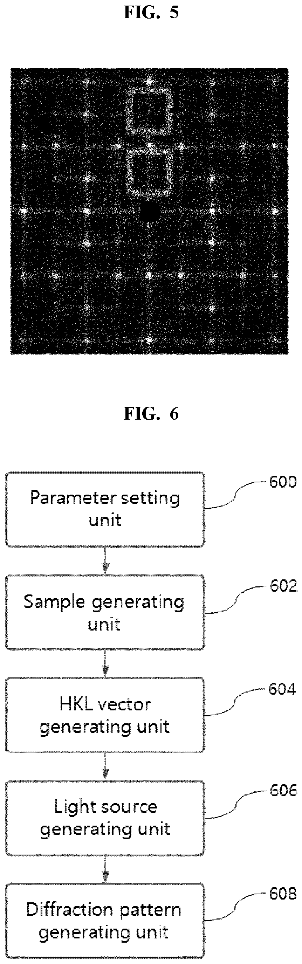

FIG. 5 is a view illustrating an SADP image to which a ringing effect occurs
FIG. 6 is a block diagram illustrating schematically a system for generating a TEM SADP image according to an embodiment of the present disclosure;

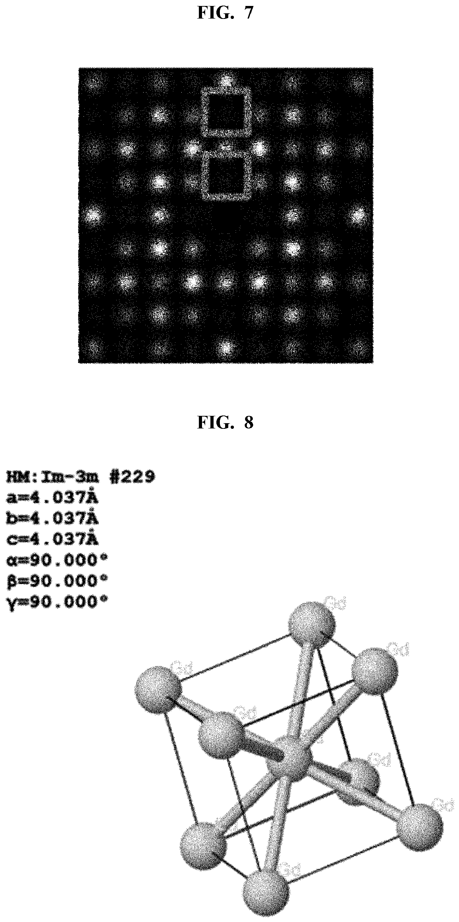

FIG. 7 is a view illustrating an SADP image to which a ringing effect does not occur generated by using a method of generating the TEM SADP image of the present disclosure;
FIG. 8 is a view illustrating an example of lattice constant of material included in a cubic system;

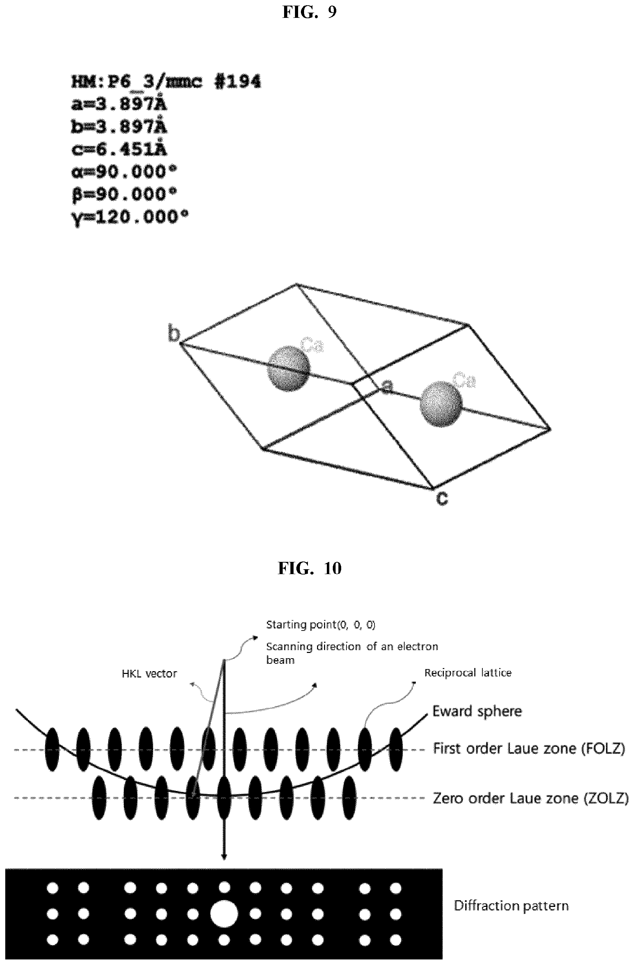

FIG. 9 is a view illustrating an example of lattice constant of material included in a hexagonal system;
FIG. 10 is a view illustrating relation among an electron beam, Eward sphere, reciprocal lattice and diffraction pattern;

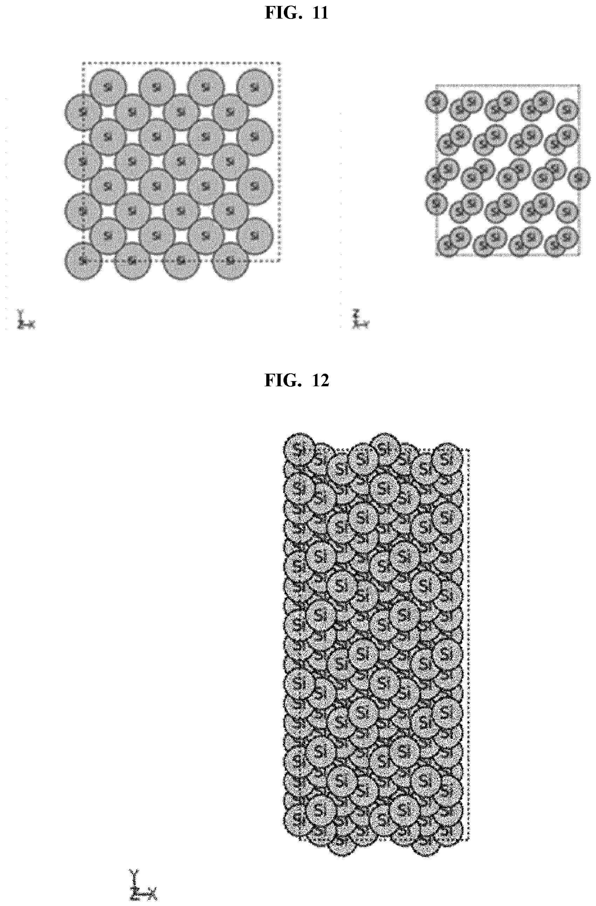

FIG. 11 is a view illustrating unit lattice before aligned and unit lattice after aligned;
FIG. 12 is a view illustrating a slab-type sample generated by using unit lattice aligned with a zone axis according to an embodiment of the present disclosure; and

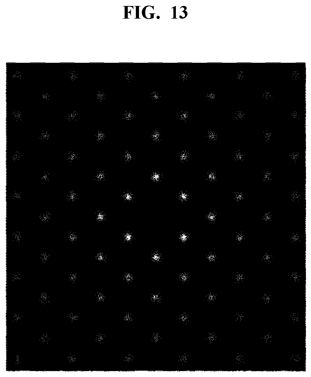

FIG. 13 is a view illustrating an example of a diffraction pattern generated by the system for generating the TEM SADP image according to the present disclosure.

DETAILED DESCRIPTION

In the present specification, an expression used in the singular encompasses the expression of the plural, unless it has a clearly different meaning in the context. In the present specification, terms such as "comprising" or "including," etc., should not be interpreted as meaning that all of the elements or operations are necessarily included. That is, some of the elements or operations may not be included, while other additional elements or operations may be further included. Also, terms such as "unit," "module," etc., as used in the present specification may refer to a part for processing at least one function or action and may be implemented as hardware, software, or a combination of hardware and software.

The present disclosure relates to a system and a method of generating adaptively a TEM (Transmission Electron Microscope) SADP (Selected Area Diffraction Pattern) image with high discernment according to inputted parameters. The system may generate excellent TEM SADP image with discernment, a ringing effect of a diffraction pattern due to a discontinuity point of a light source and a phenomenon that HOLZ (High Order Laue Zone) or blurred diffraction point is included in the diffraction pattern not being occurred to the TEM SADP image.

An SADP image is obtained by emitting an electron beam to material through a TEM to detect feature of the material, but the material may be broken down if the electron beam is emitted to the material too many times. Accordingly, the system may generate an SADP image by using a program without emitting the electron beam to the material so that the material is not broken down. The generated SADP image may be used in various fields.

Hereinafter, various embodiments of the disclosure will be described in detail with reference to accompanying drawings.

FIG. 6 is a block diagram illustrating schematically a system for generating a TEM SADP image according to an embodiment of the present disclosure, and FIG. 7 is a view illustrating an SADP image to which a ringing effect does not occur generated by using a method of generating the TEM SADP image of the present disclosure.

In FIG. 6, the system for generating a TEM SADP image of the present embodiment may generate adaptively an SADP image according to inputted parameters, the ringing effect of a diffraction pattern and a phenomenon that HOLZ or blurred diffraction point is included in the diffraction pattern not being occurred to the SADP image.

The system may include a parameter setting unit 600, a sample generating unit 602, an HKL vector generating unit 604, a light source generating unit 606, a diffraction pattern generating unit 608 and a controller (not shown) for controlling their operation. Here, the system may be embodied with one device, e.g., be a server, and it may be referred to as a computing device.

The parameter setting unit 600 may set parameters for generating the SADP image. For example, the parameter setting unit 600 may set the parameters through user's input.

In an embodiment, the parameter setting unit 600 may set parameters such as lattice constant, relative location of atom in unit lattice, a zone axis, wavelength and intensity of an electron beam, a distance to a camera, size of a diffraction pattern image and so on. Every parameter may be inputted by the user or the other parameter may be automatically generated if the user inputs a part of the parameters.

The sample generating unit 602 may generate a slab-type sample by using a parameter about the relative location of atom in unit lattice and a parameter about the zone axis. Here, the slab may have a shape of thin plate. Of course, the sample is not limited as the slab-type sample.

The HKL vector generating unit 604 may generate a reciprocal lattice vector meeting with synthetic Eward sphere. Here, the reciprocal lattice may be a parameter generated automatically by using specific program according to the unit lattice set by the parameter setting unit 600.

The light source generating unit 606 may calculate relative brightness of an electron beam reached to each of atoms in the sample.

The diffraction pattern generating unit 608 may generate synthetic SADP image by accumulating diffractions generated by interaction among every atom and every electron in the sample. In this time, the set parameters, the reciprocal lattice vector, relative brightness of the electron beam reached to the atom, etc. may be used.

Briefly, the system of generating the TEM SADP image of the present embodiment generates adaptively synthetic SADP image in response to various inputted parameters. Here, the ringing effect and the phenomenon that the HOLZ pattern or the blurred diffraction point is included in the diffraction pattern may not be occurred to the synthetic SADP image.

Additionally, the system may generate rapidly the SADP image by using parallel processing of a CPU or a GPGPU.

That is, the system may generate rapidly many synthetic SADP images. Here, the generated SADP images may be substantially identical to real SADP images.

In above description, specific parameters are mentioned as parameters inputted by the user. However, the parameter is not limited as long as the sample is generated by using the parameters inputted by the user.

That is, the system of generating the TEM SADP image may include a sample generating unit for generating the slab-type sample using the parameters inputted by the user, a light source generating unit for calculating the brightness of the electron beam reached to the atom in the sample by using a shape and intensity of the inputted light source and the diffraction pattern generating unit for generating synthetic diffraction pattern image by using the calculated brightness of the electron beam.

On the other hand, the reciprocal lattice vector, the brightness of the electron beam and the diffraction pattern may be generated by applying mathematically the parameters inputted by the user. This will be described below.

In the above, the user inputs the parameters to generate the TEM SADP image. However, the system may extract parameters from real SADP image and generate synthetic TEM SADP image using the extracted parameters. That is, the system may generate multiple synthetic TEM SADP images based on the real SADP image.

Furthermore, the number of layers of the slab, the reciprocal lattice vector and the brightness of the electron beam, etc. are not fixed, but they may be adaptively changed depending on the parameters inputted by the user or the parameters extracted from the real SADP image.

Hereinafter, a process of generating the TEM SADP image will be described in detail with reference to accompanying drawings.

FIG. 8 is a view illustrating an example of lattice constant of material included in a cubic system. FIG. 9 is a view illustrating an example of lattice constant of material included in a hexagonal system, FIG. 10 is a view illustrating relation among an electron beam, Eward sphere, reciprocal lattice and diffraction pattern, and FIG. 11 is a view illustrating unit lattice before aligned and unit lattice after aligned. FIG. 12 is a view illustrating a slab-type sample generated by using unit lattice aligned with a zone axis according to an embodiment of the present disclosure, and FIG. 13 is a view illustrating an example of a diffraction pattern generated by the system for generating the TEM SADP image according to the present disclosure.

The parameter setting unit 600 may set parameters such as lattice constant, relative location of atom in unit lattice, a zone axis, wavelength and intensity of an electron beam, distance to a camera, size of a diffraction pattern image and so on. The parameters may be inputted by the user or be extracted from real SADP image.

Here, the lattice constant and the relative location of atom in the unit lattice may be inputted with CIF (Crystallography Information File) type, FHI-aims type or XYZ type.

The sample generating unit 602 may generate the slab-type sample by using inputted parameter about the lattice constant, inputted parameter about the relative location of atom in the unit lattice and inputted parameter about the zone axis.

Particularly, the lattice constant may comprise six parameters which include a, b, c, $\alpha$, $\beta$ and $\gamma$, wherein a, b and c correspond to size of a lattice vector and $\alpha$, $\beta$ and $\gamma$ correspond to angles between the lattice vectors. Material belongs to a cubic system if a=b=c, $\alpha$ =$\beta$ =$\gamma$ =90° as shown in FIG. 8, and the material belongs to a hexagonal system if a=b$\neq$ c, $\alpha$ =$\beta$ =90°, $\gamma$ =120° as shown in FIG. 9.

The relative location of atom in the unit lattice may be expressed in following table 1 when a three-dimensional space in the unit lattice is expressed in the range of 0 to 1.

[Table 1]

| (relative location of atom in the unit lattice of LiAl material belonging to the cubic system) | | |
|---|---|---|
| Atomic symbol | Relative location | | |
| | x axis | y axis | z axis |
| Li | 0.0000 | 0.0000 | 0.5000 |
| Al | 0.0000 | 0.0000 | 0.0000 |

The sample generating unit 602 may generate the slab-type sample shown in FIG. 12 by aligning the unit lattice so that a lattice surface corresponding to the zone axis is vertical to a direction of the electron beam as shown in FIG. 11. Here, the slab-type sample may have a structure that unit lattices are disposed in platelike shape. The material in cubic system is generated in FIG. 12, but a sample in hexagonal system may be generated through the same process. Rodrigues formula may be used for aligning the direction of the electron beam in three-dimensional vector with the zone axis.

In an embodiment, the phenomenon that HOLZ or blurred diffraction point is included in the diffraction pattern may be prevented by determining adaptively the number of layers of the slab according to the inputted parameter about the lattice constant and the parameter about the zone axis.

That is, the sample generating unit 602 may determine adaptively the number of layers of the slab according to the inputted parameter about the lattice constant and the inputted parameter about the zone axis, to prevent the phenomenon that the HOLZ or blurred diffraction point is included in the diffraction pattern. Unit lattices may be aligned in the layers of the slab. As a result, the number of the layers of the slab may differ according to the parameters inputted by the user though the same material is used.

The HKL vector generating unit 604 may generate a reciprocal lattice vector meeting with synthetic Eward sphere as shown in FIG. 10. Diffraction may occur at a reciprocal lattice meeting with the Eward sphere, and thus the reciprocal lattice at which the diffraction occurs may be detected to calculate the diffraction pattern. Here, the reciprocal lattice may be parameters generated automatically by using specific program or equations according to the unit lattice set by the parameter setting unit 600.

Particularly, the HKL vector generating unit 604 may calculate a reciprocal lattice vector h(x,y), k(x,y), l(x,y) by using an image coordinate (x, y) separated from a starting point at which the electron beam locates by predetermined distance (d) and a wavelength ($\lambda$) of the electron beam as shown in following equation 1 and equation 2.

【Equation 1】

$$x = \sqrt{\left(\frac{x}{\lambda d}\right)^2 + \left(\frac{y}{\lambda d}\right)^2 + \left(\frac{1}{\lambda}\right)^2}$$

【Equation 2】

$$h(x,y) = \frac{x}{\lambda^2 d\chi}$$

$$k(x,y) = \frac{y}{\lambda^2 d\chi}$$

$$l(x,y) = \frac{1}{\lambda} - \frac{1}{\lambda^2 \chi}$$

As shown in equation 1, the HKL vector generating unit 604 may calculate $\chi$ if the image coordinate (x, y), the wavelength ($\lambda$) and the distance (d) from the starting point at which the electron beam locates are known. The reciprocal lattice vector [h(x,y), k(x,y), l(x,y)] may be automatically calculated by using the calculated $\chi$.

The light source generating unit 606 may calculate the brightness of the electron beam reached to each of atoms in the sample by using inputted shape and intensity of a light source. Here, the shape of the light source may be flat based on a lattice surface vertical to the direction of the electron beam or have 2D Gaussian shape.

The brightness of the electron beam reached to each of atoms is shown in following equation 3 if the shape of the light source is flat when 3D location of the atom in the sample is $(x_j, y_j, z_j)$.

【Equation 3】

$$I(x_j, y_j, z_j) = I_0$$

Here, $I_O$ means intensity of the light source.

The brightness of the electron beam reached to each of atoms is shown in following equation 4 if the light source has 2D Gaussian shape.

【Equation 4】

$$I(x_j, y_j, z_j) = I_0 \exp\left(-\left(\frac{(x-x_j)^2}{\sigma_x^2} + \frac{(y-y_j)^2}{\sigma_y^2}\right)\right)$$

Here, $\sigma_x$ means a standard deviation at x axis, and $\sigma_y$ means a standard deviation at y axis.

The brightness of the electron beam reached to each of atoms is shown in following equation 5 if the light source has 3D Gaussian shape.

【Equation 5】

$$I(x_j, y_j, z_j) = I_0 \exp\left(-\left(\frac{(x-x_j)^2}{\sigma_x^2} + \frac{(y-y_j)^2}{\sigma_y^2} + \frac{(z-z_j)^2}{\sigma_z^2}\right)\right)$$

Here, $\sigma_z$ means a standard deviation at z axis.

The light source generating unit 606 may use 3D Gaussian to generate continuous shape of the light source. In this case, a discontinuity point may not be occurred to an edge of the sample by setting $3\sigma$ in Gaussian to have values smaller than a width, a length and a height of the sample.

In another embodiment, the light source generating unit 606 may remove a discontinuity point occurred in a width direction and a longitudinal direction of the sample by using 2D Gaussian or remove a discontinuity point occurred in a height direction of the sample by using an exponential decay function when the 2D Gaussian and the exponential decay function are simultaneously used.

On the other hand, the light source generating unit 606 may simulate the brightness lowered according as the electron beam passes through the sample by applying the exponential decay based on a direction of the electron beam. The light source to which the exponential decay is applied may be defined in following equation 6.

【Equation 6】

$$I'(x_j, y_j, z_j) = I(x_j, y_j, z_j) \exp(-\lambda_d z_j)$$

Here, $\lambda$ a means a parameter of the exponential decay.

Size and shape of the light source generated by the light source generating unit 606 may be adaptively changed depending on inputted size of the slap and inputted size of the diffraction pattern image, etc., and thus the ringing effect of the diffraction pattern occurred from the discontinuity point of the light source may be prevented. This is shown in FIG. 7. That is, the light source generating unit 606 may change adaptively the size and the shape of the light source according to the inputted size of the slab and the inputted size of the diffraction pattern image, to prevent the ringing effect of the diffraction pattern.

The diffraction pattern generating unit 608 may calculate accumulated diffraction pattern (F(h,k,l)) by using the reciprocal lattice vector [h(x,y), k(x,y), l(x,y)] calculated by the HKL vector generating unit 604, location of atom in the sample and the brightness of the electron beam (I(xj,yj,zj)) obtained by the light source generating unit 606 as shown in following equation 7.

【Equation 7】

$$F(h, k, l) = \sum_{j=1}^{n} f_{0j}(h, k, l) I(x_j, y_j, z_j) \cos\{2\pi(hx_j + ky_j + lz_j)\}$$
$$+ i \sum_{j=1}^{n} f_{0j}(h, k, l) I(x_j, y_j, z_j) \sin\{2\pi(hx_j + ky_j + lz_j)\}$$

Here, $f_{0j}(h,k,l)$ means jth scattering factor of atom. The scattering factor may differ according to kind of the atom.

Subsequently, the diffraction pattern generating unit 608 may calculate maximum value of the accumulated diffraction pattern and generate the diffraction pattern image by normalizing linearly the accumulated diffraction pattern based on the calculated maximum value.

In another embodiment, the diffraction pattern generating unit 608 may generate the diffraction pattern image by normalizing nonlinearly the accumulated diffraction pattern using an image process technique such as a gamma correction. Here, diffraction generated from interaction of atom and electron included in the sample may be independently calculated by the diffraction pattern generating unit 608, and thus an SADP image may rapidly calculated by using parallel processing of a CPU or a GPGPU (General Purpose computing on Graphics Processing Unit). The SADP image is shown in FIG. 13. As shown in FIG. 13, the ringing effect and the phenomenon that the HOLZ or the diffraction pattern is included in the diffraction pattern don't occur to the SADP image.

On the other hand, the diffraction pattern generating unit 608 may apply accumulated diffraction values to various functions to generate the SADP image. For example, the diffraction pattern generating unit 608 may generate the diffraction pattern image by applying a linear function or generate the diffraction pattern image by using a function used for gamma correction such as $Vo = AV_i{}^\gamma$.

Briefly, the system for generating the SADP image of the present embodiment may generate the SADP image by using the reciprocal lattice vector, the location of atom in the sample and the brightness of the electron beam, wherein the ringing effect and the phenomenon that the HOLZ or the blurred diffraction point is included in the diffraction pattern are not occurred to the SADP image.

Components in the embodiments described above can be easily understood from the perspective of processes. That is, each component can also be understood as an individual process. Likewise, processes in the embodiments described above can be easily understood from the perspective of components.

Also, the technical features described above can be implemented in the form of program instructions that may be performed using various computer means and can be recorded in a computer-readable medium. Such a computer-readable medium can include program instructions, data files, data structures, etc., alone or in combination. The program instructions recorded on the medium can be designed and configured specifically for the present invention or can be a type of medium known to and used by the skilled person in the field of computer software. Examples of a computer-readable medium may include magnetic media such as hard disks, floppy disks, magnetic tapes, etc., optical media such as CD-ROM's, DVD's, etc., magneto-optical media such as floptical disks, etc., and hardware devices such as ROM, RAM, flash memory, etc. Examples of the program of instructions may include not only machine language codes produced by a compiler but also high-level language codes that can be executed by a computer through the use of an interpreter, etc. The hardware mentioned above can be made to operate as one or more software modules that perform the actions of the embodiments of the invention, and vice versa.

The embodiments of the invention described above are disclosed only for illustrative purposes. A person having ordinary skill in the art would be able to make various modifications, alterations, and additions without departing from the spirit and scope of the invention, but it is to be appreciated that such modifications, alterations, and additions are encompassed by the scope of claims set forth below.

**Claims**

1. A system for generating a diffraction pattern image comprising:

   a sample generating unit configured to generate a sample by using at least one of a parameter about a lattice constant, a parameter about relative location of atom in unit lattice and a parameter about a zone axis;
   a vector generating unit configured to generate a reciprocal lattice vector corresponding to the unit lattice;
   a light source generating unit configured to calculate brightness of an electron beam reached to atom in the generated sample; and
   a diffraction pattern generating unit configured to generate synthetic diffraction pattern image by using the generated reciprocal lattice vector, the relative location of atom in the sample and the calculated brightness of the electron beam.

2. The system of claim 1, further comprising:

   a parameter setting unit configured to set the parameter about the lattice constant, the parameter about the relative location of atom in the unit lattice, the parameter about the zone axis, a parameter about wavelength of the electron beam or a parameter about size of the diffraction pattern image,
   wherein parameters set by the parameter setting unit are inputted by a user.

3. The system of claim 1, wherein the diffraction pattern image is a TEM (Transmission Electron Microscope) SADP (Selected Area Diffraction Pattern) image.

4. The system of claim 3, wherein the sample generating unit generates a slab-type sample by aligning the unit lattice so that a direction of the zone axis is vertical to a lattice surface corresponding to the zone axis.

5. The system of claim 4, wherein the sample generating unit determines adaptively the number of layers of the slab to prevent a phenomenon that HOLZ (High Order Laue Zone) or a diffraction point is included in a diffraction pattern, depending on the parameter about the lattice constant and the parameter about the zone axis.

6. The system of claim 5, wherein the number of layers of the slab is adaptively determined considering operation amount increased in following process of calculating the diffraction pattern according as a size of the slab increases.

7. The system of claim 6, wherein parallel processing of a CPU or a GPGPU (General Purpose computing on Graphics Processing Unit) is used considering increasing of the operation amount in the process of calculating the diffraction pattern.

8. The system of claim 1, wherein the vector generating unit generates a reciprocal lattice vector meeting with Eward sphere by using an image coordinate separated from a starting point at which the electron beam locates by predetermined distance and a wavelength of the electron beam.

9. The system of claim 1, wherein the light source generating unit calculates brightness of an electron beam reached to each of atoms in the sample by using inputted shape and intensity of the light source.

10. The system of claim 9, wherein the shape and the intensity of the light source are adaptively changed depending on inputted size of a slab and inputted size of the diffraction pattern image to prevent a ringing effect of a diffraction pattern occurred from a discontinuity point of the light source.

11. The system of claim 3, wherein the diffraction pattern generating unit calculates accumulated diffraction pattern by using the generated reciprocal lattice vector, the location of atom in the sample and the calculated brightness of the electron beam.

12. The system of claim 11, wherein the diffraction pattern generating unit calculates maximum value of the accumulated diffraction pattern and generates the diffraction pattern image by normalizing linearly the accumulated diffraction pattern based on the calculated maximum value,
and wherein the diffraction pattern generating unit changes the diffraction pattern image by applying a gamma correction to the diffraction pattern image so that a diffraction point having low brightness included in the diffraction pattern image is better seen.

13. The system of claim 3, wherein the diffraction pattern generating unit calculates accumulated diffraction pattern by using the calculated reciprocal lattice vector, the relative location of atom in the sample and the calculated brightness of the electron beam, calculates maximum value of the accumulated diffraction pattern and generates the diffraction pattern image by normalizing nonlinearly the accumulated diffraction pattern using an image processing technique for using a gamma correction based on the calculated maximum value.

14. A system for generating a diffraction pattern image comprising:

a sample generating unit configured to generate a slab-type sample by using parameters inputted by a user; and
a diffraction pattern generating unit configured to generate the diffraction pattern image by using parameters obtained by analyzing the generated sample,
wherein the sample generating unit determines adaptively the number of layers of a slab according to a parameter about a lattice constant and a parameter about a zone axis of the inputted parameters.

15. The system of claim 14, wherein the diffraction pattern generating unit generates the diffraction pattern image by using a reciprocal lattice vector meeting with Eward sphere in the sample, location of atom in the sample and brightness of an electron beam reached to the atom in the sample.

16. A system for generating a diffraction pattern image comprising:

a sample generating unit configured to generate a slab-type sample by using parameters inputted by a user;
a light source generating unit configured to calculate brightness of an electron beam reached to atom in the sample by using inputted shape and intensity of a light source; and
a diffraction pattern generating unit configured to generate synthetic diffraction pattern image by using location of atom in the sample and the calculated brightness of the electron beam,
wherein the shape and the intensity of the light source is adaptively changed depending on inputted size of a slab or inputted size of the diffraction pattern image, to prevent a ringing effect of a diffraction pattern occurred from a discontinuity point of the light source.

17. A recording medium readable by a computer recording a program code, wherein the program code is used for performing a method comprising:

generating a sample by using at least one of a parameter about a lattice constant, a parameter about relative location of atom in unit lattice and a parameter about a zone axis;
generating a reciprocal lattice vector meeting with Eward sphere corresponding to the unit lattice;
calculating brightness of an electron beam reached to atom in the sample by using inputted shape and intensity of a light source; and

generating synthetic diffraction pattern image by using the generated reciprocal lattice vector, the relative location of atom in the sample and the calculated brightness of the electron beam,
wherein the diffraction pattern image is a TEM SADP image.

**FIG. 1**

**FIG. 2**

FIG. 3

FIG. 4

## FIG. 5

## FIG. 6

Parameter setting unit — 600

Sample generating unit — 602

HKL vector generating unit — 604

Light source generating unit — 606

Diffraction pattern generating unit — 608

**FIG. 7**

**FIG. 8**

HM:Im-3m #229
a=4.037Å
b=4.037Å
c=4.037Å
α=90.000°
β=90.000°
γ=90.000°

## FIG. 9

HM:P6_3/mmc #194
a=3.897Å
b=3.897Å
c=6.451Å
α=90.000°
β=90.000°
γ=120.000°

## FIG. 10

**FIG. 11**

**FIG. 12**

FIG. 13

## INTERNATIONAL SEARCH REPORT

| International application No. |
| --- |
| **PCT/KR2022/015357** |

### A. CLASSIFICATION OF SUBJECT MATTER

**G06T 11/00**(2006.01)i; **G06T 3/40**(2006.01)i; **G06N 3/08**(2006.01)i

According to International Patent Classification (IPC) or to both national classification and IPC

### B. FIELDS SEARCHED

Minimum documentation searched (classification system followed by classification symbols)

G06T 11/00(2006.01); G01B 11/25(2006.01); G01N 23/20(2006.01); G01N 23/203(2006.01); G02B 27/02(2006.01); G02B 5/18(2006.01); H01J 37/21(2006.01); H01J 37/22(2006.01); H01J 37/28(2006.01); H04N 5/235(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 분별력(discernment), TEM(Transmission Electron Microscope), SADP(Selected Area Diffraction Pattern), 격자(lattice), 정대축(zone axis), 파라미터(parameter), 시료(sample), 벡터(vector), 전자빔(electron beam), 밝기(brightness), 광원(light source), 원자(atom), 회절(diffraction), 패턴(pattern), 역격자(reciprocal lattice), HOLZ(Higher Order Laue Zone), 링잉 효과(ringing effect), Ewald sphere, slab

### C. DOCUMENTS CONSIDERED TO BE RELEVANT

| Category* | Citation of document, with indication, where appropriate, of the relevant passages | Relevant to claim No. |
| --- | --- | --- |
| Y | JP 6255494 B2 (HITACHI HIGH-TECHNOLOGIES CORPORATION) 27 December 2017 (2017-12-27) See paragraphs [0002], [0009], [0017], [0025], [0028], [0030], [0051] and [0057]; and figures 1-3. | 1-4,8-17 |
| A | | 5-7 |
| Y | JP 2000-039409 A (RIGAKU CORP.) 08 February 2000 (2000-02-08) See paragraphs [0007] and [0016]; claim 1; and figure 6. | 1-4,8-13,15-17 |
| Y | KR 10-2021-0122161 A (FEI COMPANY) 08 October 2021 (2021-10-08) See paragraphs [0001], [0006] and [0031]; and figure 2. | 3-4,10-13,16-17 |
| Y | KR 10-2020-0028406 A (MICRO-EPSILON MESSTECHNIK GMBH & CO. KG) 16 March 2020 (2020-03-16) See paragraphs [0073] and [0078]; and claims 1-2. | 12-13 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **02 February 2023** | **03 February 2023** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2022/015357** |

### C. DOCUMENTS CONSIDERED TO BE RELEVANT

| Category* | Citation of document, with indication, where appropriate, of the relevant passages | Relevant to claim No. |
| --- | --- | --- |
| Y | JP 2020-523634 A (VUZIX CORPORATION) 06 August 2020 (2020-08-06)<br>See paragraphs [0012]-[0013] and [0089]. | 14-15 |
| A | KR 10-2221931 B1 (OXFORD INSTRUMENTS NANOTECHNOLOGY TOOLS LIMITED) 02 March 2021 (2021-03-02)<br>See paragraphs [0048]-[0062]. | 1-17 |

Form PCT/ISA/210 (second sheet) (July 2022)

<table>
<tr><td colspan="2" align="center"><strong>INTERNATIONAL SEARCH REPORT</strong><br>Information on patent family members</td><td colspan="2">International application No.<br><strong>PCT/KR2022/015357</strong></td></tr>
</table>

| Patent document cited in search report | | | Publication date (day/month/year) | Patent family member(s) | | | Publication date (day/month/year) |
|---|---|---|---|---|---|---|---|
| JP | 6255494 | B2 | 27 December 2017 | CN | 106663584 | A | 10 May 2017 |
| | | | | CN | 106663584 | B | 30 October 2018 |
| | | | | DE | 112015002590 | B4 | 01 April 2021 |
| | | | | DE | 112015002590 | T5 | 27 April 2017 |
| | | | | JP | WO2016-006375 | A1 | 27 April 2017 |
| | | | | US | 2017-0133195 | A1 | 11 May 2017 |
| | | | | US | 9754762 | B2 | 05 September 2017 |
| | | | | WO | 2016-006375 | A1 | 14 January 2016 |
| JP | 2000-039409 | A | 08 February 2000 | EP | 0959345 | A2 | 24 November 1999 |
| | | | | EP | 0959345 | A3 | 17 October 2001 |
| | | | | EP | 0959345 | B1 | 24 March 2010 |
| | | | | JP | 2003-294656 | A | 15 October 2003 |
| | | | | JP | 3889183 | B2 | 07 March 2007 |
| | | | | JP | 3954936 | B2 | 08 August 2007 |
| | | | | US | 2003-0009316 | A1 | 09 January 2003 |
| | | | | US | 7337098 | B2 | 26 February 2008 |
| KR | 10-2021-0122161 | A | 08 October 2021 | CN | 113466273 | A | 01 October 2021 |
| | | | | EP | 3901980 | A2 | 27 October 2021 |
| | | | | EP | 3901980 | A3 | 22 December 2021 |
| | | | | JP | 2021-163756 | A | 11 October 2021 |
| | | | | US | 11404241 | B2 | 02 August 2022 |
| | | | | US | 2021-0305012 | A1 | 30 September 2021 |
| KR | 10-2020-0028406 | A | 16 March 2020 | CN | 110832271 | A | 21 February 2020 |
| | | | | CN | 110832271 | B | 11 November 2022 |
| | | | | DE | 102017211377 | A1 | 10 January 2019 |
| | | | | DE | 102017211377 | B4 | 14 January 2021 |
| | | | | EP | 3479059 | A1 | 08 May 2019 |
| | | | | JP | 2020-527225 | A | 03 September 2020 |
| | | | | JP | 7016892 | B2 | 07 February 2022 |
| | | | | US | 11125550 | B2 | 21 September 2021 |
| | | | | US | 2020-0158498 | A1 | 21 May 2020 |
| | | | | US | 2021-0364277 | A1 | 25 November 2021 |
| | | | | WO | 2019-007468 | A1 | 10 January 2019 |
| JP | 2020-523634 | A | 06 August 2020 | CN | 110914724 | A | 24 March 2020 |
| | | | | CN | 113281839 | A | 20 August 2021 |
| | | | | EP | 3635456 | A1 | 15 April 2020 |
| | | | | EP | 3635456 | A4 | 13 January 2021 |
| | | | | US | 11086059 | B2 | 10 August 2021 |
| | | | | US | 2020-0209630 | A1 | 02 July 2020 |
| | | | | US | 2022-0050232 | A1 | 17 February 2022 |
| | | | | WO | 2018-231754 | A1 | 20 December 2018 |
| KR | 10-2221931 | B1 | 02 March 2021 | CN | 106165055 | A | 23 November 2016 |
| | | | | CN | 106165055 | B | 19 July 2019 |
| | | | | KR | 10-2016-0119840 | A | 14 October 2016 |
| | | | | US | 10663414 | B2 | 26 May 2020 |
| | | | | US | 2016-0356729 | A1 | 08 December 2016 |
| | | | | WO | 2015-121603 | A1 | 20 August 2015 |

Form PCT/ISA/210 (patent family annex) (July 2022)